# DEMANDE DE BREVET EUROPEEN

(11) **EP 3 859 973 A1**
(43) Date de publication de la demande: **04.08.2021**
(21) Numéro de dépôt: 21152402.0
(22) Date de dépôt: 19.01.2021
(51) Int. Cl.: H03K 19/0175

(54) **MICROCONTRÔLEUR COMPRENANT DES OSCILLATEURS CONFIGURÉS POUR RECEVOIR DES SIGNAUX DE RÉSONATEURS EXTERNES**

(30) Priorité: 31.01.2020 FR 2000993
(71) Demandeur: STMicroelectronics (Rousset) SAS, 13790 Rousset (FR)
(72) Inventeur: GAMET, Arnaud, 83910 POURRIERES (FR); LE FEVRE, Philippe, 13090 AIX EN PROVENCE (FR)
(74) Mandataire: Casalonga

(57) **Abrégé**

Un aspect de l'invention concerne un microcontrôleur comprenant :
- au moins une paire de cellules d'entrée/sortie configurées pour pouvoir être connectée à un premier résonateur externe,
- un premier oscillateur et un deuxième oscillateur,
et dans lequel au moins une paire, dite paire partagée, parmi ladite au moins une paire de cellules d'entrée/sortie est également configurée pour pouvoir être connectée à un deuxième résonateur externe, le microcontrôleur comprenant en outre un circuit de commutation entre ladite paire partagée de cellules d'entrée/sortie et les premier et deuxième oscillateurs, le circuit de commutation étant configuré pour pouvoir connecter soit le premier oscillateur soit le deuxième oscillateur à la paire de cellules d'entrée/sortie.

## Description

Des modes de réalisation de l'invention concernent les microcontrôleurs, notamment ceux comprenant des oscillateurs configurés pour recevoir des signaux de résonateurs externes.

On connait des microcontrôleurs comprenant plusieurs paires de cellules d'entrée/sortie configurées pour pouvoir être connectées à des résonateurs externes. En particulier, chacune de ces paires de cellules d'entrée/sortie est configurée pour pouvoir être connectée à un unique résonateur externe. Ces microcontrôleurs comprennent également des oscillateurs connectés à ces paires de cellules d'entrée/sortie. En particulier chaque oscillateur est connecté à une unique paire de cellules d'entrée/sortie pour recevoir un signal émis par le résonateur externe connecté à cette paire de cellules d'entrée/sortie.

Plus particulièrement, ces microcontrôleurs comprennent un oscillateur haute fréquence et un oscillateur basse fréquence. L'oscillateur haute fréquence est connecté à une première paire de cellules d'entrée/sortie configurée pour pouvoir être connectée à un résonateur externe haute fréquence. L'oscillateur basse fréquence est connecté à une deuxième paire de cellules d'entrée/sortie configurée pour pouvoir être connectée à un résonateur externe basse fréquence.

De tels microcontrôleurs nécessitent d'attribuer deux paires de cellules d'entrée/sortie pour le fonctionnement de l'oscillateur haute fréquence et de l'oscillateur basse fréquence. En outre, ces deux oscillateurs ne sont pas toujours utilisés par l'utilisateur final qui préfère n'en choisir qu'un sur les deux.

Or, il existe un besoin dans certaines applications de réduire le nombre de cellules d'entrée/sortie du microcontrôleur. Cette réduction du nombre de cellules d'entrée/sortie peut entraîner l'utilisateur à utiliser des résonateurs internes au microcontrôleur qui peuvent être moins précis que des résonateurs externes.

Il existe donc un besoin de proposer un microcontrôleur configuré pour pouvoir utiliser deux oscillateurs à partir de deux résonateurs externes en réduisant le nombre de cellules d'entrée/sortie attribuées pour le fonctionnement de ces deux oscillateurs.

En outre, en utilisant un microcontrôleur de l'art antérieur, l'utilisateur est généralement limité dans ses choix de conception d'une carte électronique comprenant le microcontrôleur et chaque résonateur externe. En particulier, ses choix de conception sont limités par l'emplacement des paires de cellules d'entrée/sortie configurées pour être connectées aux résonateurs externes.

Il existe donc également un besoin de proposer un microcontrôleur qui permette d'offrir une plus grande flexibilité dans les choix de conception d'une carte électronique comprenant le microcontrôleur et des résonateurs externes connectés à ce micro contrôleur.

Selon un aspect, il est proposé un microcontrôleur comprenant :
- au moins une paire de cellules d'entrée/sortie configurées pour pouvoir être connectée à un premier résonateur externe,
- un premier oscillateur et un deuxième oscillateur,
et dans lequel au moins une paire, dite paire partagée, parmi ladite au moins une paire de cellules d'entrée/sortie est également configurée pour pouvoir être connectée à un deuxième résonateur externe, le microcontrôleur comprenant en outre un circuit de commutation entre ladite paire partagée de cellules d'entrée/sortie et les premier et deuxième oscillateurs, le circuit de commutation étant configuré pour pouvoir connecter soit le premier oscillateur soit le deuxième oscillateur à la paire partagée de cellules d'entrée/sortie.

Un tel microcontrôleur permet à un utilisateur final d'utiliser une même paire de cellules d'entrée/sortie pour bénéficier de deux résonateurs externes.

Un tel microcontrôleur permet également de réduire le nombre de cellules d'entrée/sortie dédiées à l'utilisation des oscillateurs. En effet, un tel microcontrôleur permet de mutualiser une paire de cellules d'entrée/sortie pour l'utilisation de deux oscillateurs.

En particulier, dans les microcontrôleurs de l'art antérieur, l'utilisation de deux oscillateurs nécessite d'attribuer deux paires de cellules d'entrée/sortie pour le fonctionnement des deux oscillateurs. Un microcontrôleur selon cet aspect de l'invention permet donc de réduire de deux le nombre de cellules d'entrée/sortie dédiées à l'utilisation des oscillateurs par rapport à ces microcontrôleurs connus. Un tel microcontrôleur permet donc de sauver deux cellules d'entrée/sortie. Ces deux cellules d'entrée/sortie sauvées peuvent alors être dédiées à une autre utilisation.

De préférence, le microcontrôleur comprend une pluralité de paires partagées de cellules d'entrée/sortie.

En effet, l'utilisateur peut choisir la paire de cellules d'entrée/sortie à laquelle connecter un résonateur en fonction d'une localisation souhaitée de résonateurs sur une carte électronique comprenant le microcontrôleur.

Un tel microcontrôleur permet donc d'offrir une plus grande flexibilité dans les choix de conception d'une carte électronique comprenant ce microcontrôleur et les résonateurs externes.

Par ailleurs, de préférence, le microcontrôleur comprend une unité de commande configurée pour commander le circuit de commutation afin de connecter soit le premier oscillateur soit le deuxième oscillateur à la paire de cellules d'entrée/sortie.

Dans un mode de réalisation avantageux, chaque paire partagée de cellules d'entrée/sortie comprend :
- une première cellule utilisée comme sortie vers le premier résonateur et le deuxième résonateur, et
- une deuxième cellule utilisée comme entrée pour le premier résonateur et le deuxième résonateur.

Dans un mode de réalisation avantageux, pour chaque paire partagée de cellules d'entrée/sortie, le circuit de commutation comprend des chemins, dits premiers chemins principaux, configurés pour :
- connecter électriquement une entrée du premier oscillateur à une première entrée de la deuxième cellule de cette paire partagée,
- connecter électriquement une sortie du premier oscillateur à une première sortie de la première cellule de cette paire partagée, chaque premier chemin principal comprenant un interrupteur entre le premier oscillateur et la cellule à laquelle ce premier chemin principal est relié.

Les interrupteurs des premiers chemins principaux reliés à une même paire partagée de cellules d'entrée/sortie peuvent être basculés dans un état fermé dans lequel ils permettent de connecter électriquement le premier oscillateur à cette même paire partagée de cellules d'entrée/sortie.

Les interrupteurs des premiers chemins principaux reliés à une même paire partagée de cellules d'entrée/sortie peuvent être basculés dans un état ouvert dans lequel ils permettent de déconnecter électriquement le premier oscillateur de cette même paire partagée de cellules d'entrée/sortie.

En particulier, l'unité de commande peut être configurée pour basculer dans un état fermé l'interrupteur de chaque premier chemin principal relié à une même paire partagée de cellules d'entrée/sortie de façon à pouvoir relier électriquement le premier oscillateur à un premier résonateur externe connecté à cette paire partagée de cellules d'entrée/sortie.

L'unité de commande peut également être configurée pour basculer dans un état ouvert l'interrupteur de chaque premier chemin principal relié à une même paire partagée de cellules d'entrée/sortie de façon à déconnecter le premier oscillateur du premier résonateur externe connecté à cette paire partagée de cellules d'entrée/sortie.

Dans un mode de réalisation avantageux, pour chaque paire partagée de cellules d'entrée/sortie, le circuit de commutation comprend en outre des chemins, dits deuxièmes chemins principaux, pour :
- connecter électriquement une entrée du deuxième oscillateur à une deuxième entrée de la deuxième cellule de cette paire partagée,
- connecter électriquement une sortie du deuxième oscillateur à une deuxième sortie de la première cellule de cette paire partagée,
chaque deuxième chemin principal comprenant un interrupteur entre le deuxième oscillateur et la cellule à laquelle ce deuxième chemin principal est relié.

Les interrupteurs des deuxièmes chemins principaux reliés à une même paire partagée de cellules d'entrée/sortie peuvent être basculés dans un état fermé dans lequel ils permettent de connecter électriquement le deuxième oscillateur à cette même paire partagée de cellules d'entrée/sortie.

Les interrupteurs des premiers chemins principaux reliés à une même paire partagée de cellules d'entrée/sortie peuvent être basculés dans un état ouvert dans lequel ils permettent de déconnecter électriquement le deuxième oscillateur de cette même paire partagée de cellules d'entrée/sortie.

En particulier, l'unité de commande peut être configurée pour basculer dans un état fermé l'interrupteur de chaque deuxième chemin principal relié à une même paire partagée de cellules d'entrée/sortie de façon à pouvoir relier électriquement le deuxième oscillateur à un deuxième résonateur externe connecté à cette paire partagée de cellules d'entrée/sortie.

En outre, l'unité de commande peut être configurée pour basculer dans un état ouvert l'interrupteur de chaque deuxième chemin principal relié à une même paire partagée de cellules d'entrée/sortie de façon à déconnecter le deuxième oscillateur du deuxième résonateur externe connecté à cette paire partagée de cellules d'entrée/sortie.

L'unité de commande peut être configurée pour basculer les interrupteurs dans un état fermé soit pour les premiers chemins principaux soit pour les deuxièmes chemins principaux.

En particulier, l'unité de commande peut être configurée de sorte que lorsque l'interrupteur de chaque deuxième chemin principal est commandé dans un état ouvert, l'interrupteur de chaque premier chemin principal est commandé dans un état fermé. En outre, l'unité de commande peut être configurée de sorte que lorsque l'interrupteur de chaque premier chemin principal est commandé dans un état ouvert, l'interrupteur de chaque deuxième chemin principal est commandé dans un état fermé.

Dans un mode de réalisation avantageux, pour chaque paire partagée de cellules d'entrée/sortie, le circuit de commutation comprend en outre des chemins, dits premiers chemins secondaires, configurés pour :
- connecter électriquement la sortie du premier oscillateur à la deuxième sortie de la première cellule de cette paire partagée,
- connecter électriquement l'entrée du premier oscillateur à la deuxième entrée de la deuxième cellule de cette paire partagée,
chaque premier chemin secondaire comprenant un interrupteur entre le premier oscillateur et la cellule à laquelle ce premier chemin secondaire est relié.

Les premiers chemins secondaires permettent d'offrir à un utilisateur final de choisir sur quelles entrée/sortie d'une paire de cellules d'entrée/sortie connecter un résonateur externe avec le premier oscillateur.

Les interrupteurs des premiers chemins secondaires reliés à une même paire partagée de cellules d'entrée/sortie peuvent être basculés dans un état fermé dans lequel ils permettent de connecter électriquement le premier oscillateur à cette même paire partagée de cellules d'entrée/sortie.

Les interrupteurs des premiers chemins secondaires reliés à une même paire partagée de cellules d'entrée/sortie peuvent être basculés dans un état ouvert dans lequel ils permettent de déconnecter électriquement le premier oscillateur de cette même paire partagée de cellules d'entrée/sortie.

En particulier, l'unité de commande peut être configurée pour basculer dans un état fermé l'interrupteur de chaque premier chemin secondaire relié à une même paire de cellules d'entrée/sortie partagée de façon à pouvoir relier électriquement le premier oscillateur au deuxième résonateur externe connecté à cette paire partagée de cellules d'entrée/sortie.

L'unité de commande peut également être configurée pour basculer dans un état ouvert l'interrupteur de chaque premier chemin secondaire relié à une même paire partagée de cellules d'entrée/sortie de façon à déconnecter le premier oscillateur du deuxième résonateur externe connecté à cette paire partagée de cellules d'entrée/sortie.

En particulier, l'unité de commande peut être configurée de sorte que lorsque l'interrupteur de chaque premier chemin secondaire est commandé dans un état ouvert, l'interrupteur de chaque premier et deuxième chemin principal est commandé dans un état fermé.

En outre, l'unité de commande peut être configurée de sorte que lorsque l'interrupteur de chaque premier chemin principal ou de chaque deuxième chemin principal est commandé dans un état ouvert, l'interrupteur de chaque premier chemin secondaire est commandé dans un état fermé.

Dans un mode de réalisation avantageux, pour chaque paire partagée de cellules d'entrée/sortie, le circuit de commutation comprend en outre des chemins, dits premiers chemins de compensation, reliant chaque premier chemin secondaire au premier oscillateur, à partir d'un nœud disposé entre l'interrupteur de ce premier chemin secondaire et la cellule d'entrée/sortie à laquelle ce premier chemin secondaire est relié, de façon à former une boucle de rétroaction.

Dans un mode de réalisation avantageux, pour chaque paire partagée de cellules d'entrée/sortie, le circuit de commutation comprend en outre des chemins, dits deuxièmes chemins secondaires, configurés pour :
- connecter électriquement la sortie du deuxième oscillateur à la première sortie de la première cellule,
- connecter électriquement l'entrée du deuxième oscillateur à la première entrée de la deuxième cellule,
chaque deuxième chemin secondaire comprenant un interrupteur entre le deuxième oscillateur et la cellule à laquelle ce deuxième chemin secondaire est relié.

Les deuxièmes chemins secondaires permettent d'offrir à un utilisateur final de choisir sur quelles entrée/sortie d'une paire de cellules d'entrée/sortie connecter un résonateur externe avec le deuxième oscillateur.

Les interrupteurs des deuxièmes chemins secondaires reliés à une même paire partagée de cellules d'entrée/sortie peuvent être basculés dans un état fermé dans lequel ils permettent de connecter électriquement le premier oscillateur à cette même paire partagée de cellules d'entrée/sortie.

Les interrupteurs des deuxièmes chemins secondaires reliés à une même paire partagée de cellules d'entrée/sortie peuvent être basculés dans un état ouvert dans lequel ils permettent de déconnecter électriquement le premier oscillateur de cette même paire partagée de cellules d'entrée/sortie.

En particulier, l'unité de commande peut être configurée pour basculer dans un état fermé l'interrupteur de chaque deuxième chemin secondaire relié à une même paire partagée de cellules d'entrée/sortie de façon à pouvoir relier électriquement le deuxième oscillateur au premier résonateur externe connecté à cette paire partagée de cellules d'entrée/sortie.

L'unité de commande peut également être configurée pour basculer dans un état ouvert l'interrupteur de chaque deuxième chemin secondaire relié à une même paire partagée de cellules d'entrée/sortie de façon à déconnecter le deuxième oscillateur du premier résonateur externe connecté à cette paire partagée de cellules d'entrée/sortie.

L'unité de commande peut être configurée pour basculer dans un état fermé soit les interrupteurs des premiers chemins principaux soit les interrupteurs des deuxièmes chemins principaux soit les interrupteurs des premiers chemins secondaires, soit les interrupteurs des deuxièmes chemins secondaires.

En particulier, l'unité de commande peut être configurée de sorte que lorsque l'interrupteur de chaque deuxième chemin secondaire est commandé dans un état ouvert, les interrupteurs de chaque premier et deuxième chemin principal et de chaque premier chemin secondaire sont commandés dans un état fermé.

En outre, l'unité de commande peut être configurée de sorte que lorsque l'interrupteur de chaque premier chemin principal ou de chaque deuxième chemin principal ou de chaque premier chemin secondaire est commandé dans un état ouvert, l'interrupteur de chaque deuxième chemin secondaire est commandé dans un état fermé.

Dans un mode de réalisation avantageux, pour chaque paire partagée de cellules d'entrée/sortie, le circuit de commutation comprend en outre des chemins, dits deuxièmes chemins de compensation, reliant chaque deuxième chemin secondaire au deuxième oscillateur, à partir d'un nœud disposé entre l'interrupteur de ce deuxième chemin secondaire et la cellule d'entrée/sortie à laquelle ce deuxième chemin secondaire est relié, de façon à former une boucle de rétroaction.

Chaque oscillateur est configuré pour délivrer un signal oscillant présentant une fréquence donnée à partir d'un signal émis par un résonateur fonctionnant à ladite fréquence donnée.

Dans un mode de réalisation avantageux, le premier oscillateur est configuré pour recevoir un signal oscillant ayant une fréquence de l'ordre de 32 kHz. Le premier oscillateur est alors un oscillateur basse fréquence.

Dans un mode de réalisation avantageux, le deuxième oscillateur est configuré pour recevoir un signal oscillant ayant une fréquence comprise entre 4 MHz et 50MHz. Le deuxième oscillateur est alors un oscillateur haute fréquence.

Dans un mode de réalisation avantageux, le circuit de commutation est configuré pour être tolérant à une tension de 5V.

Selon un autre aspect, il est proposé une carte électronique comprenant :
- un microcontrôleur tel que décrit précédemment,
- un résonateur externe connectés à une paire partagée de cellules d'entrée/sortie du microcontrôleur.

D'autres avantages et caractéristiques de l'invention apparaîtront à l'examen de la description détaillée de modes de réalisation, nullement limitatifs, et des dessins annexés sur lesquels :
[Fig 1]
[Fig 2]
[Fig 3]
[Fig 4]
[Fig 5]

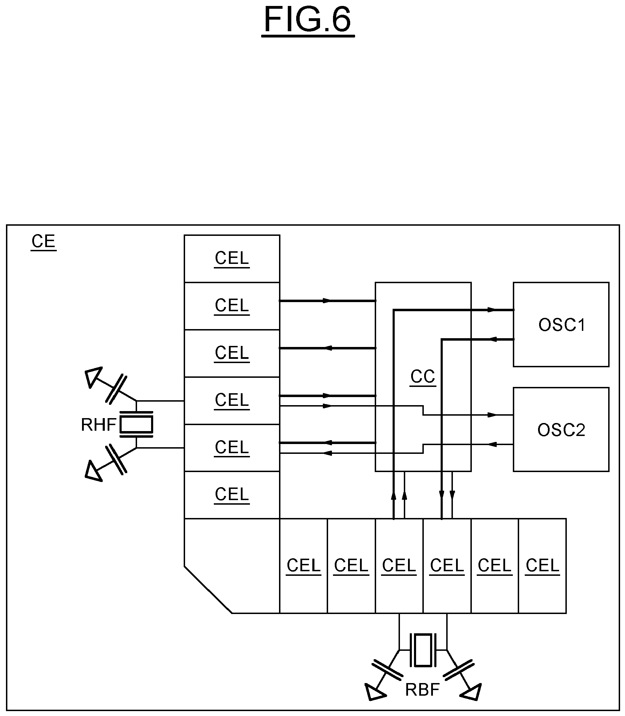

[Fig 6] illustrent schématiquement des modes de réalisation de l'invention.

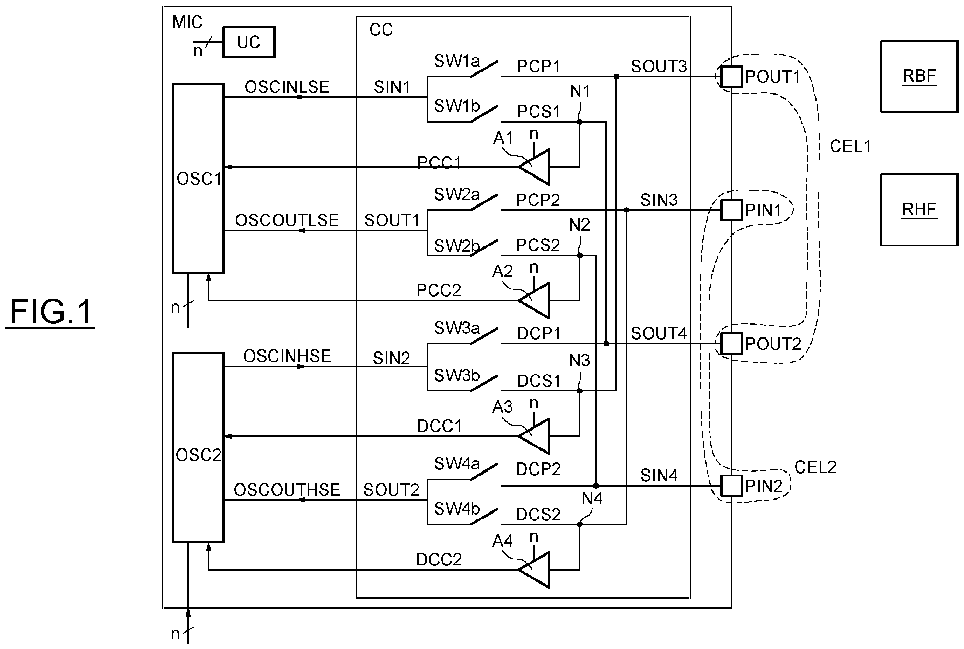

La figure 1 représente un microcontrôleur MIC selon un mode de réalisation de l'invention comprenant deux oscillateurs OSC1, OSC2.

Un premier oscillateur OSC1 peut être utilisé comme oscillateur basse fréquence configuré pour fonctionner à partir d'un signal électrique oscillant délivré par un résonateur externe basse fréquence RBF. En particulier le premier oscillateur OSC1 est configuré pour recevoir un signal électrique oscillant ayant une fréquence de l'ordre de 32kHz et pour amplifier ce signal oscillant.

Un deuxième oscillateur OSC2 peut être utilisé comme oscillateur haute fréquence configuré pour fonctionner à partir d'un signal électrique délivré par un résonateur externe haute fréquence RHF. En particulier, le deuxième oscillateur OSC2 est configuré pour recevoir un signal électrique oscillant ayant une fréquence comprise entre 4MHz et 50MHz et pour amplifier ce signal oscillant.

Les résonateurs externes RBF, RHF peuvent être connectés à des paires de cellules d'entrée/sortie CEL1, CEL2 du microcontrôleur.

Sur la figure 1, à des fins de compréhension, une seule paire de cellules d'entrée/sortie est représentée. Néanmoins, il est possible de prévoir plusieurs paires de cellules d'entrée/sortie.

La paire de cellules d'entrée/sortie CEL1, CEL2 est configurée de façon à pouvoir être connectée à un premier résonateur externe et/ou à un deuxième résonateur externe. Le premier résonateur peut être un résonateur basse fréquence RBF apte à délivrer un signal électrique oscillant ayant une fréquence de l'ordre de 32kHz. Le deuxième résonateur peut être un résonateur externe haute fréquence RHF apte à délivrer un signal électrique oscillant ayant une fréquence comprise entre 4MHz et 50MHz.

La paire de cellules d'entrée/sortie CEL1, CEL2 comprend une première cellule d'entrée/sortie CEL1 utilisée dans la description qui suit comme sortie vers les résonateurs externes RBF, RHF et une deuxième cellule d'entrée/sortie CEL2 utilisée dans la description qui suit comme entrée vers les oscillateurs OSC1, OSC2.

Chaque résonateur RBF, RHF peut être connecté de façon à avoir une première borne connectée à la cellule CEL1 et une deuxième borne connectée à la cellule CEL2.

En particulier, la cellule CEL1 comprend une première entrée PIN1 et une deuxième entrée PIN2. La cellule CEL2 comprend une première sortie POUT1 et une deuxième sortie POUT2.

Le premier résonateur peut être connecté à la première entrée PIN1 de la cellule CEL1 et la première sortie POUT1 de la cellule CEL2.

Le deuxième résonateur peut être connecté à la deuxième entrée PIN2 de la cellule CEL1 et la deuxième sortie POUT2 de la cellule CEL2.

La paire de cellules d'entrée/sortie CEL1, CEL2 représentée à la figure 1 est dite partagée car elle peut être connectée à deux résonateurs externes.

Le microcontrôleur MIC comprend également un circuit de commutation CC relié électriquement d'un côté aux oscillateurs OSC1, OSC2 et d'un autre côté à la paire de cellules d'entrée/sortie CEL1, CEL2. Bien entendu, il est possible de prévoir un circuit de commutation configuré pour être connecté à plusieurs paires de cellules d'entrée/sortie, partagées ou non.

Dans le mode de réalisation représenté à la figure 1, le circuit de commutation CC comprend :
- une première entrée SIN1 configurée pour recevoir un signal OSCINLSE d'une sortie du premier oscillateur OSC1,
- une première sortie SOUT1 configurée pour délivrer un signal OSCOUTLSE vers une entrée du premier oscillateur OSC1,
- une deuxième entrée SIN2 configurée pour recevoir un signal OSCINHSE d'une sortie du deuxième oscillateur OSC2,
- une deuxième sortie SOUT2 configurée pour délivrer un signal OSCOUTHSE vers une entrée du deuxième oscillateur OSC2.

Le circuit de commutation comprend également :
- une troisième sortie SOUT3 reliée à la première sortie POUT1 de la première cellule d'entrée/sortie CEL1,
- une troisième entrée SIN3 reliée à la première entrée PIN1 de la deuxième cellule d'entrée/sortie CEL2,
- une quatrième sortie SOUT4 reliée à la deuxième sortie POUT2 de la première cellule d'entrée/sortie CEL1,
- une quatrième entrée SIN4 reliée à la deuxième entrée PIN2 de la deuxième cellule d'entrée/sortie CEL2.

Le circuit de commutation comprend en outre des chemins, dits premiers chemins principaux PCP1, PCP2, utilisés pour connecter le premier oscillateur OSC1 à la sortie POUT1 et à l'entrée PIN1 respectivement.

En particulier, le premier chemin principal PCP1 relie la première entrée SIN1 à la troisième sortie SOUT3 à travers un interrupteur SW1a du circuit de commutation CC. Le premier chemin principal PCP2 relie la troisième entrée SIN3 à la première sortie SOUT1 à travers un interrupteur SW2a du circuit de commutation CC.

Le circuit de commutation CC comprend en outre des chemins, dits deuxièmes chemins principaux DCP1, DCP2, utilisés pour connecter le deuxième oscillateur OSC2 à la sortie POUT2 et à l'entrée PIN2 respectivement.

En particulier, le deuxième chemin principal DCP1 relie la deuxième entrée SIN2 à la quatrième sortie SOUT4 à travers un interrupteur SW3a du circuit de commutation CC. Le deuxième chemin principal DCP2 relie la quatrième entrée SIN4 à la deuxième sortie SOUT2 à travers un interrupteur SW4a du circuit de commutation CC.

Le circuit de commutation CC comprend en outre des chemins, dits premiers chemins secondaires, PCS1, PCS2 utilisés pour connecter le premier oscillateur OSC1 à la sortie POUT2 et à l'entrée PIN2 respectivement.

En particulier, le premier chemin secondaire PCS1 relie la première entrée SIN1 à la quatrième sortie SOUT4 à travers un interrupteur SW1b du circuit de commutation CC. Le premier chemin secondaire PCS2 relie la quatrième entrée SIN4 à la première sortie SOUT1 à travers un interrupteur SW2b du circuit de commutation.

Le circuit de commutation comprend en outre des chemins, dits deuxièmes chemins secondaires DCS1, DCS2, utilisés pour connecter le deuxième oscillateur OSC2 à la sortie POUT1 et à l'entrée PIN1 respectivement.

En particulier, le deuxième chemin secondaire DCS1 relie la deuxième entrée SIN2 à la troisième sortie SOUT3 à travers un interrupteur SW3b du circuit de commutation CC. Le deuxième chemin secondaire DCS2 relie la troisième entrée SIN3 à la deuxième sortie POUT2 à travers un interrupteur SW4b du circuit de commutation CC.

Le circuit de commutation CC comprend en outre des premiers chemins, dits premiers chemins de compensation PCC1, PCC2, reliant chaque premier chemin secondaire PCS1, PCS2 à l'oscillateur OSC1 auquel ce premier chemin secondaire PCS1, PCS2 est relié, de façon à former une boucle de rétroaction.

En particulier, le circuit de commutation comprend un premier chemin de compensation PCC1 s'étendant jusqu'à l'oscillateur OSC1 à partir d'un nœud N1 disposé entre l'interrupteur SW1b du premier chemin secondaire de sortie PCS1 et la sortie SOUT4.

Le circuit de commutation comprend également un premier chemin de compensation PCC2 s'étendant jusqu'à l'oscillateur OSC1 à partir d'un nœud N2 disposé entre l'interrupteur SW2b du premier chemin secondaire de sortie PCS2 et l'entrée SIN4.

Chaque premier chemin de compensation PCC1, PCC2 comprend en outre un amplificateur suiveur A1, A2 disposé entre le nœud N1, N2 et l'oscillateur OSC1 respectivement. Ainsi, les premiers chemins de compensation PCC1, PCC2 permettent de compenser la distance entre l'oscillateur OSC1 et un résonateur lorsque ces derniers sont reliés l'un à l'autre par les premiers chemins secondaires PCS1 et PCS2.

Le circuit de commutation comprend en outre des chemins, dits deuxièmes chemins de compensation DCC1, DCC2, reliant chaque deuxième chemin secondaire DCS1, DCS2 à l'oscillateur OSC2 auquel ce deuxième chemin secondaire DCS1, DCS2 est relié, de façon à former une boucle de rétroaction.

En particulier, le circuit de commutation comprend un deuxième chemin de compensation DCC1 s'étendant jusqu'à l'oscillateur OSC2 à partir d'un nœud N3 disposé entre l'interrupteur SW3b du deuxième chemin secondaire de sortie DCS1 et la sortie SOUT3.

Le circuit de commutation comprend également un deuxième chemin de compensation DCC2 s'étendant jusqu'à l'oscillateur OSC2 à partir d'un nœud N4 disposé entre l'interrupteur SW4b du deuxième chemin secondaire de sortie DCS2 et l'entrée SIN3.

Chaque deuxième chemin de compensation DCC1, DCC2 comprend en outre un amplificateur suiveur A3, A4 disposé entre le nœud N3, N4 et l'oscillateur OSC2 respectivement. Ainsi, les deuxièmes chemins de compensation DCC1, DCC2 permettent de compenser la distance entre l'oscillateur OSC2 et un résonateur lorsque ces derniers sont reliés l'un à l'autre par les deuxièmes chemins secondaires DCS1 et DCS2.

Par ailleurs, le circuit de commutation CC est configuré pour être tolérant à 5V.

Le microcontrôleur MIC comprend également une unité de commande UC configurée pour commander les interrupteurs SW1a, SW1b, SW2a, SW2b, SW3a, SW3b, SW4a et SW4b du circuit de commutation CC. L'unité de commande UC peut être un processeur.

En particulier, l'unité de commande UC est configurée pour connecter :
- soit le premier oscillateur OSC1 à l'entrée PIN1 et à la sortie POUT1 de la paire de cellules d'entrée/sortie CEL1, CEL2 en fermant les interrupteurs SW2a et SW1a des premiers chemins principaux PCP2, PCP1 respectivement ;
- soit le deuxième oscillateur OSC2 à l'entrée PIN2 et à la sortie POUT2 de la paire de cellules d'entrée/sortie CEL1, CEL2 en fermant les interrupteurs SW4a et SW3a respectivement des deuxièmes chemins principaux DCP2, DCP1 ;
- soit le premier oscillateur OSC1 à l'entrée PIN2 et à la sortie POUT2 de la paire de cellules d'entrée/sortie CEL1, CEL2 en fermant les interrupteurs SW2b et SW1b des premiers chemins secondaires PCS2, PCS1 respectivement ;
- soit le deuxième oscillateur OSC2 à l'entrée PIN1 et à la sortie POUT1 de la paire de cellules d'entrée/sortie CEL1, CEL2 en fermant les interrupteurs SW4b et SW3b des deuxièmes chemins secondaires DCS2, DCS1 respectivement.

Généralement, un utilisateur final choisira de connecter sur la paire de cellules d'entrée/sortie CEL1, CEL2 soit un premier résonateur censé fonctionner avec le premier oscillateur OSC1, soit un deuxième résonateur censé fonctionner avec le deuxième oscillateur OSC2.

L'unité de commande UC sera alors programmée pour commander les interrupteurs SW1a, SW1b, SW2a, SW2b, SW3a, SW3b, SW4a et SW4b du circuit de commutation CC en fonction de l'entrée PIN1, PIN2 et de la sortie POUT1, POUT2 de la paire de cellules d'entrée/sortie CEL1, CEL1 auxquelles le résonateur sera connecté.

Ainsi, par exemple, si l'utilisateur souhaite connecter un résonateur basse fréquence sur l'entrée PIN1 et la sortie POUT1 de la paire de cellules d'entrée/sortie CEL1, CEL2, l'unité de commande UC sera programmée pour fermer les interrupteurs SW2a et SW1a de façon à connecter le premier oscillateur OSC1 basse fréquence à ce résonateur basse fréquence.

En outre, si l'utilisateur souhaite connecter un résonateur basse fréquence sur l'entrée PIN2 et la sortie POUT2 de la paire de cellules d'entrée/sortie CEL1, CEL2, l'unité de commande UC sera programmée pour fermer les interrupteurs SW2b et SW1b de façon à connecter le premier oscillateur OSC1 basse fréquence à ce résonateur basse fréquence.

De même, si l'utilisateur souhaite connecter un résonateur haute fréquence sur l'entrée PIN2 et la sortie POUT2 de la paire de cellules d'entrée/sortie CEL1, CEL2, l'unité de commande UC sera programmée pour fermer les interrupteurs SW4a et SW3a de façon à connecter le deuxième oscillateur OSC2 haute fréquence à ce résonateur haute fréquence.

En outre, si l'utilisateur souhaite connecter un résonateur haute fréquence sur l'entrée PIN1 et la sortie POUT1 de la paire de cellules d'entrée/sortie CEL1, CEL2, l'unité de commande UC sera programmée pour fermer les interrupteurs SW4b et SW3b de façon à connecter le deuxième oscillateur OSC2 haute fréquence à ce résonateur haute fréquence.

Un bus, par exemple un bus à n bits, est connecté aux oscillateurs OSC1, OSC2 et à l'unité de commande UC. Ce bus véhicule un signal de commande, par exemple de n bits, permettant à l'utilisateur (à l'aide des valeurs logiques des n bits) d'indiquer aux oscillateurs et à l'unité de commande l'emplacement du résonateur. À partir de cette information, l'unité de commande UC commande les interrupteurs SW1a, SW1b, SW2a, SW2b, SW3a, SW3b, SW4a, SW4b pour connecter le résonateur à l'oscillateur OSC1, OSC2 souhaité. Cet oscillateur peut également adapter son amplification du signal généré par le résonateur en fonction de l'emplacement du résonateur. Les amplificateurs A1, A2, A3 et A4 sont également commandés par le signal de commande véhiculé par le bus.

Un tel microcontrôleur permet donc à un utilisateur final d'utiliser une même paire de cellules d'entrée/sortie pour bénéficier de deux résonateurs externes.

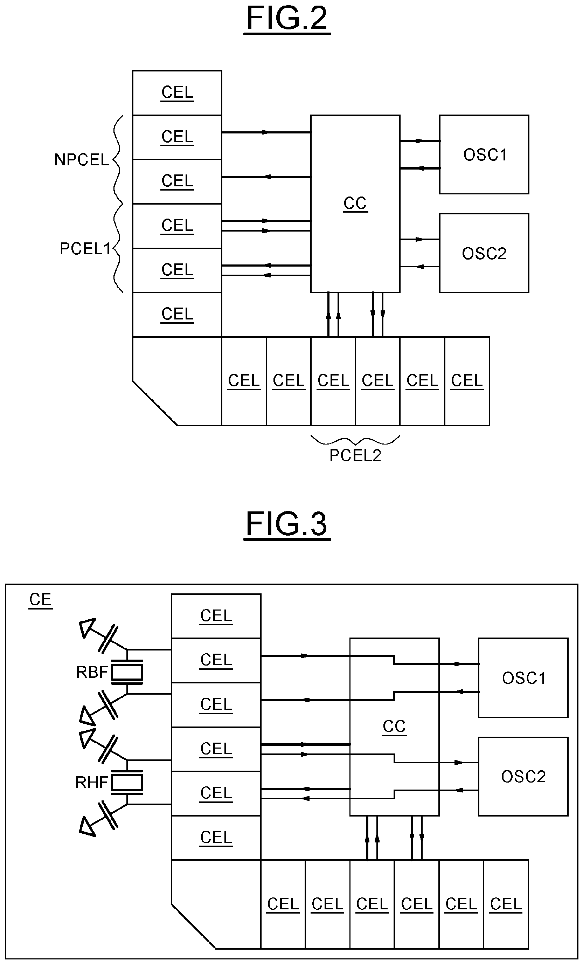

D'autres modes de réalisation d'un microcontrôleur MIC sont représentés aux figures 2 à 6.

Dans ces modes de réalisation, le microcontrôleur MIC comprend deux oscillateurs OSC1, OSC2. L'oscillateur OSC1 est un oscillateur basse fréquence et l'oscillateur OSC2 est un oscillateur haute fréquence.

Le microcontrôleur MIC comprend également une pluralité de cellules d'entrée/sortie CEL dont une paire NPCEL de cellules d'entrée/sortie non partagée, une première paire PCEL1 de cellules d'entrée/sortie partagée et une deuxième paire PCEL2 de cellules d'entrée/sortie partagée.

Le microcontrôleur MIC comprend également un circuit de commutation CC relié aux deux oscillateurs OSC1, OSC2, à la paire NPCEL de cellules d'entrée/sortie non partagée et aux deux paires PCEL1, PCEL2 de cellules d'entrée/sortie partagées.

Un tel microcontrôleur permet d'offrir une plus grande flexibilité dans les choix de conception d'une carte électronique comprenant ce microcontrôleur et les résonateurs externes.

En effet, l'utilisateur peut choisir la paire de cellules d'entrée/sortie à laquelle connecter un résonateur en fonction d'une localisation souhaitée de résonateurs sur une carte électronique comprenant le microcontrôleur.

En particulier, comme représenté sur une carte électronique CE à la figure 3, si l'utilisateur final souhaite connecter un résonateur basse fréquence RBF sur la paire NPCEL de cellules d'entrée/sortie non partagée et un résonateur haute fréquence RHF sur la paire PCEL1 de cellules d'entrée/sortie partagée, l'unité de commande UC sera programmée pour commander les interrupteurs du circuit de commutation CC pour connecter l'oscillateur OSC1 basse fréquence à la paire NPCEL de cellules d'entrée/sortie non partagée et pour connecter l'oscillateur OSC2 haute fréquence à la paire PCEL1 de cellules d'entrée/sortie partagée.

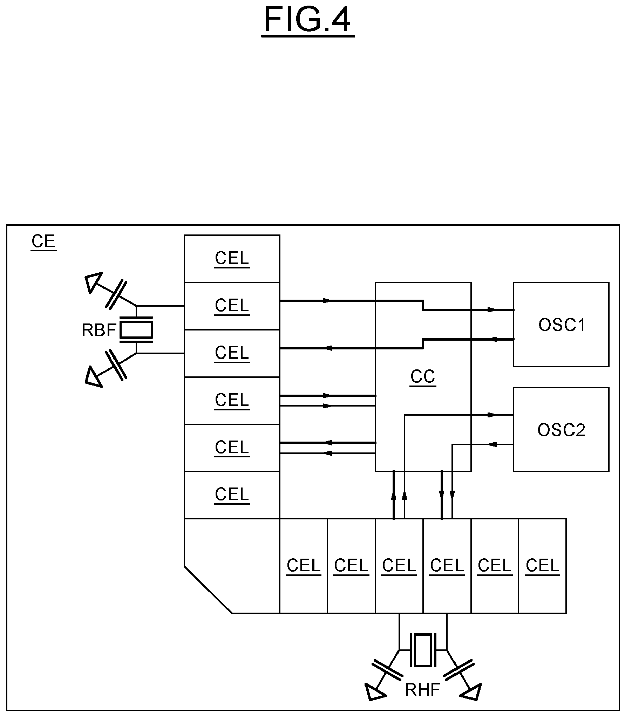

En outre, comme représenté sur une carte électronique CE à la figure 4, si l'utilisateur final souhaite connecter un résonateur basse fréquence RBF sur la paire NPCEL de cellules d'entrée/sortie non partagée et un résonateur haute fréquence RHF sur la paire PCEL2 de cellules d'entrée/sortie partagée, l'unité de commande UC sera programmée pour commander les interrupteurs du circuit de commutation CC pour connecter l'oscillateur OSC1 basse fréquence à la paire NPCEL de cellules d'entrée/sortie non partagée et pour connecter l'oscillateur OSC2 haute fréquence à la paire PCEL2 de cellules d'entrée/sortie partagée.

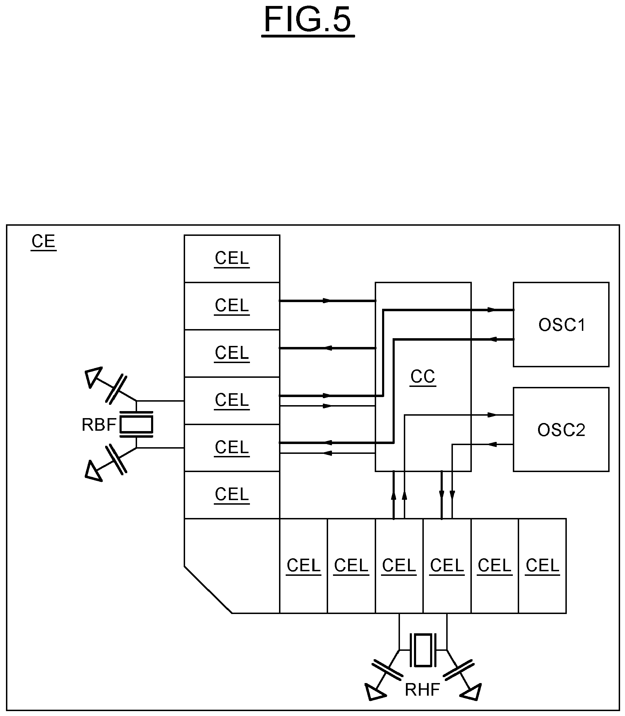

En variante, comme représenté sur une carte électronique CE à la figure 5, si l'utilisateur final souhaite connecter un résonateur basse fréquence RBF sur la paire PCEL1 de cellules d'entrée/sortie partagée et un résonateur haute fréquence RHF sur la paire PCEL2 de cellules d'entrée/sortie partagée, l'unité de commande UC sera programmée pour commander les interrupteurs du circuit de commutation CC pour connecter l'oscillateur OSC1 basse fréquence à la paire PCEL1 de cellules d'entrée/sortie et pour connecter l'oscillateur OSC2 haute fréquence à la paire PCEL2 de cellules d'entrée/sortie partagée.

En variante, comme représenté sur une carte électronique CE à la figure 6, si l'utilisateur final souhaite connecter un résonateur basse fréquence RBF sur la paire PCEL2 de cellules d'entrée/sortie partagée et un résonateur haute fréquence RHF sur la paire PCEL1 de cellules d'entrée/sortie partagée, l'unité de commande UC sera programmée pour commander les interrupteurs du circuit de commutation CC pour connecter l'oscillateur OSC1 basse fréquence à la paire PCEL2 de cellules d'entrée/sortie non partagée et pour connecter l'oscillateur OSC2 haute fréquence à la paire PCEL1 de cellules d'entrée/sortie partagée.

Dans ces modes de réalisation, les cellules d'entrée/sortie non utilisées pour connecter les résonateurs externes peuvent être utilisées pour d'autres applications.

## Revendications

1. Microcontrôleur comprenant :
- au moins une paire de cellules d'entrée/sortie (CEL1, CEL2) configurées pour pouvoir être connectée à un premier résonateur externe,
- un premier oscillateur (OSC1) et un deuxième oscillateur (OSC2),
et dans lequel au moins une paire, dite paire partagée, parmi ladite au moins une paire de cellules d'entrée/sortie est également configurée pour pouvoir être connectée à un deuxième résonateur externe, le microcontrôleur comprenant en outre un circuit de commutation (CC) entre ladite paire partagée de cellules d'entrée/sortie et les premier et deuxième oscillateurs (OSC1, OSC2), le circuit de commutation (CC) étant configuré pour pouvoir connecter soit le premier oscillateur (OSC1) soit le deuxième oscillateur (OSC2) à la paire partagée de cellules d'entrée/sortie (CEL1, CEL2).

2. Microcontrôleur selon la revendication 1, dans lequel chaque paire partagée de cellules d'entrée/sortie comprend :
- une première cellule (CEL1) utilisée comme sortie vers le premier résonateur et le deuxième résonateur, et
- une deuxième cellule (CEL2) utilisée comme entrée pour le premier résonateur et le deuxième résonateur.

3. Microcontrôleur selon la revendication 2 dans lequel pour chaque paire partagée de cellules d'entrée/sortie, le circuit de commutation (CC) comprend des chemins, dits premiers chemins principaux (PCP1, PCP2), configurés pour :
- connecter électriquement une entrée du premier oscillateur (OSC1) à une première entrée (PIN1) de la deuxième cellule (CEL2) de cette paire partagée,
- connecter électriquement une sortie du premier oscillateur (OSC1) à une première sortie (POUT1) de la première cellule (CEL1) de cette paire partagée,
chaque premier chemin principal (PCP1, PCP2) comprenant un interrupteur (SW1a, SW2a) entre le premier oscillateur (OSC1) et la cellule (CEL1, CEL2) à laquelle ce premier chemin principal (PCP1, PCP2) est relié.

4. Microcontrôleur selon la revendication 3 dans lequel pour chaque paire partagée de cellules d'entrée/sortie, le circuit de commutation (CC) comprend en outre des chemins, dits deuxièmes chemins principaux (DCP1, DCP2), pour :
- connecter électriquement une entrée du deuxième oscillateur (OSC2) à une deuxième entrée (PIN2) de la deuxième cellule de cette paire partagée,
- connecter électriquement une sortie du deuxième oscillateur à une deuxième sortie (POUT2) de la première cellule de cette paire partagée,
chaque deuxième chemin principal (DCP1, DCP2) comprenant un interrupteur (SW3a, SW4a) entre le deuxième oscillateur (OSC2) et la cellule à laquelle ce deuxième chemin principal est relié.

5. Microcontrôleur selon la revendication 4 dans lequel pour chaque paire partagée de cellules d'entrée/sortie, le circuit de commutation (CC) comprend en outre des chemins, dits premiers chemins secondaires (PCS1, PCS2), configurés pour :
- connecter électriquement la sortie du premier oscillateur à la deuxième sortie (POUT2) de la première cellule (CEL1) de cette paire partagée,
- connecter électriquement l'entrée du premier oscillateur à la deuxième entrée (PIN2) de la deuxième cellule (CEL2) de cette paire partagée,
chaque premier chemin secondaire (PCS1, PCS2) comprenant un interrupteur (SW1b, SW2b) entre le premier oscillateur (OSC1) et la cellule à laquelle ce premier chemin secondaire est relié.

6. Microcontrôleur selon la revendication 5, dans lequel, pour chaque paire partagée de cellules d'entrée/sortie, le circuit de commutation (CC) comprend en outre des chemins, dits premiers chemins de compensation (PCC1, PCC2), reliant chaque premier chemin secondaire (PCS1, PCS2) au premier oscillateur (OSC1), à partir d'un nœud disposé entre l'interrupteur (SW1b, SW2b) de ce premier chemin secondaire (PCS1, PCS2) et la cellule d'entrée/sortie (CEL1, CEL2) à laquelle ce premier chemin secondaire (PCS1, PCS2) est relié, de façon à former une boucle de rétroaction.

7. Microcontrôleur selon l'une des revendications 4 à 6 dans lequel pour chaque paire partagée de cellules d'entrée/sortie, le circuit de commutation (CC) comprend en outre des chemins, dits deuxièmes chemins secondaires (DCS1, DCS2), configurés pour :
- connecter électriquement la sortie du deuxième oscillateur (OSC2) à la première sortie (POUT1) de la première cellule (CEL1),
- connecter électriquement l'entrée du deuxième oscillateur (OSC2) à la première entrée (PIN1) de la deuxième cellule (CEL2),
chaque deuxième chemin secondaire (DCS1, DCS2) comprenant un interrupteur (SW3b, SW4b) entre le deuxième oscillateur (OSC2) et la cellule à laquelle ce deuxième chemin secondaire (DCS1, DCS2) est relié.

8. Microcontrôleur selon la revendication 7, dans lequel, pour chaque paire partagée de cellules d'entrée/sortie, le circuit de commutation (CC) comprend en outre des chemins, dits deuxièmes chemins de compensation (DCC1, DCC2), reliant chaque deuxième chemin secondaire (DCS1, DCS2) au deuxième oscillateur (OSC2), à partir d'un nœud disposé entre l'interrupteur (SW3b, SW4b) de ce deuxième chemin secondaire (DCS1, DCS2) et la cellule d'entrée/sortie (CEL1, CEL2) à laquelle ce deuxième chemin secondaire (DCS1, DCS2) est relié, de façon à former une boucle de rétroaction.

9. Microcontrôleur selon l'une des revendications 1 à 8 dans lequel le premier oscillateur (OSC1) est configuré pour recevoir un signal oscillant ayant une fréquence de l'ordre de 32 kHz.

10. Microcontrôleur selon l'une des revendications 1 à 9 dans lequel le deuxième oscillateur (OSC2) est configuré pour recevoir un signal oscillant ayant une fréquence comprise entre 4 MHz et 50MHz.

11. Microcontrôleur selon l'une des revendications 1 à 10 dans lequel le circuit de commutation (CC) est configuré pour être tolérant à une tension de 5V.

12. Carte électronique comprenant :
- un microcontrôleur selon l'une des revendications 1 à 11,
- un résonateur externe connecté à une paire partagée de cellules d'entrée/sortie du microcontrôleur.
